# EUROPEAN PATENT SPECIFICATION

(11) **EP 3 569 349 B1**
(45) Date of publication and mention of the grant of the patent: **17.03.2021**
(21) Application number: 18173335.3
(22) Date of filing: 18.05.2018
(51) Int. Cl.: B23K 37/04, B23K 37/047, B25J 15/06, B23K 31/02, H01L 31/05, H01L 31/18, B23K 101/18, B23K 101/40, B23K 103/00

(54) **DEVICE FOR GRIPPING AND WELDING SOLAR CELLS TO RELATED ELECTRICAL CONNECTORS AND ASSOCIATED ACTUATING HEAD, AND ROBOT**
VORRICHTUNG ZUM GREIFEN UND SCHWEISSEN VON SOLARZELLEN AN ZUGEHÖRIGE ELEKTRISCHE VERBINDER UND ZUGEHÖRIGER BETÄTIGUNGSKOPF, UND ROBOTER
DISPOSITIF DE PRÉHENSION ET DE SOUDAGE DE CELLULES SOLAIRES À DES CONNECTEURS ÉLECTRIQUES CORRESPONDANTS ET TÊTE D'ACTIONNEMENT ET ROBOT ASSOCIÉS

(43) Date of publication of application: 20.11.2019
(73) Proprietor: SUPSI (Scuola Universitaria Professionale Della Svizzera Italiana), 6928 Manno (CH)
(72) Inventor: Valente, Anna, 6984 Pura (CH); Brugnetti, Ivan, 6983 Magliaso (CH); Colla, Marco, 6600 Muralto (CH)
(74) Representative: Pasquino, Fabio

(56) References cited:
- CN-B- 105 244 418
- JP-A- S6 224 994
- JP-A- S63 181 398
- JP-A- 2011 088 165

## Description

The present invention relates to the field of robotics devices and to the manipulation of components of string of solar cells. In particular, the present invention relates to a device for gripping and welding solar cells to related electrical connectors to define a string of solar cells, as defined in the preamble of claim 1 (see for example CN 105 244 418 B).

In a further aspect, the present invention relates to an actuating head for gripping and welding electronic solar cells for a robotic arm, see claim 4.

Finally, in a further aspect, the present invention relates to a robot for gripping and welding solar cells to related electrical connectors, see claim 7.

### Background art

Solar cells are typically installed in such a way as to form a string, or sequence of solar cells, which develops primarily along a single orientation direction. In this string, solar cells are electrically connected in series through suitable electrical connectors. In particular, the electrical connector is made in such a way as to be arranged at the front and/or rear of each solar cell to achieve a coupling of the N-P-N-P type, i.e. in which the positive pole of a solar cell is connected to the negative pole of the solar cell which is next in the string.

Optionally, two or more of these strings of solar cells can be further connected to each other in parallel by defining an array of solar cells, connecting the positive pole of a string to the positive pole of the adjacent string and proceeding in a similar manner with negative poles.

For the connection of the solar cells, a strip-type electrical connector can be used which is positioned over a solar cell and extended so as to constitute the electrical contact for the following solar cell. The latter is, in fact, subsequently deposited over the portion of the strip-type electrical connector that comes out of the solar cell that precedes it. A new strip-type electrical connector is then deposited, and the procedure is repeated until the desired solar cell string is completed. The electrical connection between each solar cell and the strip-type electrical connector is ensured by welding the aforementioned components.

These operations are performed manually and involve the need for considerable precision by the operator performing the couplings. In the event that the connection between the solar cell and the relevant strip-type electrical connector is not correctly performed, localized electrical resistance increases may occur that significantly worsen the efficiency of the solar cell string. Moreover, any weldings carried out incorrectly pose a serious risk to the electrical integrity of the string of solar cells increasing the probability of subsequent revisions, with the addition of direct costs related to the same revision and indirect costs related to the impossibility of using the string during review operations.

The miniaturization of solar cells and electrical connectors also makes their handling extremely difficult due to the fragility of the components, the reduced size of the connector and the particular sensitivity with respect to the quality of the welding to be carried out. Manual manipulation makes this last inconvenience particularly important because, due to the aforementioned miniaturization, the positioning of the solar cells and electrical connectors with the precision required by the welding specifications is difficult to achieve with the manual assembly, or at least requires an assembly implying long times and high costs.

Therefore, there is the need for a device and a method for gripping and welding solar cells with related electrical connectors for the construction of a string of solar cells, which allows their quick, precise and reliable handling and mutual welding, thus contributing to solve the aforementioned drawbacks.

### Summary of the invention

The object of the present invention is to provide a device for gripping and welding solar cells with corresponding electrical connectors for the construction of a string of solar cells capable of minimizing the aforementioned drawbacks.

According to the present invention, a device for gripping and welding solar cells with corresponding electrical connectors for the construction of a string of solar cells is defined in claim 1. The device for gripping and welding comprises suction means able to hold in use the solar cell or the electrical connector and defining a gripping area of the solar cell or of the electrical connector and welding means of the electrical connector to the solar cell and defining a welding area of the electrical connector, able to heat during use the welding area for melting the electrical connector; the suction means and the welding means are aligned along an alignment axis parallel to the gripping area and to the welding area, and the suction means are movable with respect to the welding means between a gripping position, wherein the means of suction retain the solar cell or the electrical connector spaced from the welding area, and a welding position, wherein the suction means retain the electrical connector at the welding area in contact with the welding means during the melting of the welding layer of the electrical connector.

The aforesaid device therefore allows an automatic welding of electrical connectors to the relative solar cells for the definition of a string of solar cells. Moreover, both the solar cells and the electrical connectors are therefore not in contact with the welding means during handling, eliminating the risk of accidental damage.

According to the present invention, the suction means consist of two suction ducts aligned along the alignment axis.

The plurality of ducts used and their arrangement allows to improve the grip of the solar cells and of the corresponding electrical conductors, minimizing the portion of the gripping area in which to arrange the aforesaid suction means.

The welding means comprise a welding tip which defines the welding area. Further according to the present invention, the suction ducts and the welding tip are aligned along the alignment axis, and the welding tip is arranged side by side with the suction ducts.

The relative arrangement between the welding tip and the suction ducts allows to optimize the steps for the realization of the string obtaining a device optimized for the execution of the necessary steps.

The device for gripping and welding comprises elastic means operatively connected to the suction ducts for moving the suction ducts between the gripping position and the welding position, and vice versa; the elastic means are pre-tensioned to keep the suction ducts in the gripping position and allow the suction ducts to be arranged in the welding position when the suction ducts are subjected to pressure on a support.

The use of the elastic means allows to easily achieve the desired effect related to the handling of the suction means. In addition, the pre-tensioning of the same allows to obtain the desired pressure of the sealing means on the electrical connector and on the relative solar cell on which it is welded.

Preferably, the device for gripping and welding comprises a support frame and positioning means of the suction means and the welding means to the support frame; the positioning means are able to allow the relative movement of the suction means and the welding means with respect to the support frame to modify the positioning of the gripping area with respect to the welding area in the gripping position. Even more preferably, the positioning means comprise a first support bracket, able to operatively connect the suction means to the support frame, and a second support bracket, able to operatively connect the welding means to the support frame; the suction means and the welding means are able to move, respectively to the first support bracket and the second support bracket, along a direction perpendicular to the alignment axis.

The relative movement allows to adapt the suction means and welding means for the use of the device for gripping and welding in a plurality of related conditions, for example, to different solar cells and/or electrical connectors.

The purpose mentioned above is further achieved by an actuating head for a robotic arm for gripping and welding solar cells with corresponding electrical connectors for the construction of a string of solar cells as defined in claim 4. The actuating head comprises a device for gripping and welding solar cells with corresponding electrical connectors for the realization of a string of solar cells, as described above, and an interface device provided with a coupling flange for the robotic arm and able to operatively connecting the device for gripping and welding to the robotic arm; the device for gripping and welding comprises at least a first mechanical interface pin, the interface device comprises at least a first mechanical interface connector able to mate with the first mechanical interface pin, and the first mechanical interface pin and the first mechanical interface connector respectively have a through-opening which defines, when coupled, a first air duct for feeding the suction means.

The use of an actuating head of the aforesaid type allows to handle in an automatic manner the device for gripping and welding, as well as to obtain a high flexibility in the use of different devices for gripping and welding as a function of conformation of the elements to be moved and/or the process to be carried out. In addition, the use of hollow mechanical interface connectors reduces costs and setup times of the actuating head.

Preferably, the interface device comprises compressed air feeding means and at least one Venturi device, operatively connected to the compressed air feeding means and to the suction means, to obtain suction force to the suction means through the feeding of compressed air into the Venturi device.

Preferably, the device for gripping and welding comprises a first mechanical interface pin and a second mechanical interface pin and the interface device comprises a first mechanical interface connector and a second mechanical interface connector; the first mechanical interface connector and/or the second mechanical interface connector are actuatable between an operating position, in which the first mechanical interface connector and/or the second mechanical interface connector are respectively coupled to the first mechanical interface pin and/or to the second mechanical interface pin, and a resting position, in which the first mechanical interface connector and/or the second mechanical interface connector are respectively decoupled from the first mechanical interface pin and/or from the second mechanical interface pin, and the interface device comprises an electric motor operatively connected to the first mechanical interface connector and/or the second mechanical interface connector to modify the mutual distance between the first connector and the second mechanical interface connector.

In this way, it is possible to achieve different spacings between the two connectors in order to obtain the coupling between the interface device and a plurality of different devices for gripping and welding.

Again, the above-mentioned purpose is achieved by a robot for gripping and welding solar cells with corresponding electrical connectors for the realization of a string of solar cells as defined in claim 7. The robot comprises an actuating head for gripping and welding solar cells with respective electrical connectors, as described above, a robotic arm provided with an end comprising a housing flange for the coupling flange and a computerized and programmable data processing unit able to control the movement of the robotic arm and/or of the actuating head for gripping and welding; the data processing unit is able to control the control unit of the interface device for actuating the welding means of the device for gripping and welding.

### Description of the figures

These and further features and advantages of the present invention will become apparent from the disclosure of the preferred embodiment, illustrated by way of a non-limiting example in the accompanying figures, wherein:
- Figure 1 shows a perspective view of a portion of the device for gripping and welding, according to the present invention;
- Figure 2 shows a perspective view of the actuating head comprising the device for gripping and welding, according to the present invention;
- Figure 3 shows a front plan view in section of the actuating head of Figure 2;
- Figure 4 shows a perspective view of the actuating head comprising the gripping and welding device during the picking and holding phase of the electrical connector, according to the present invention;
- Figures 5A-5E show a front plan view of the actuating head comprising the gripping and welding device during the execution of the steps for welding the electrical connector to the solar cell, according to the present invention;
- Figures 6A-6C show a front plan view of the actuating head comprising the gripping and welding device during the execution of the steps for arranging a solar cell adjacent to the preceding solar cell, according to the present invention.

### Detailed description of the invention.

The present invention relates to a device for gripping and welding, in particular specifically designed for making strings of solar cells. This device for gripping and welding is able to be coupled to a robotic arm (not shown), for example by means of an actuating head for gripping and welding.

The term *"solar cell string"* means, in the present invention, a sequence of solar cells which develop mainly along a single orientation direction and are electrically connected to each other in series by suitable electrical connectors.

The device for gripping and welding is therefore designed to move solar cells 1 and electrical connectors 2, the latter able to be coupled by welding to the aforementioned solar cells 1 for making the string of solar cells. In the following, reference will be made to electrical connectors 2 of the strip or microstrip type, or rather made of strips of conductive material whose development is substantially planar and which have a substantially rectangular profile in section.

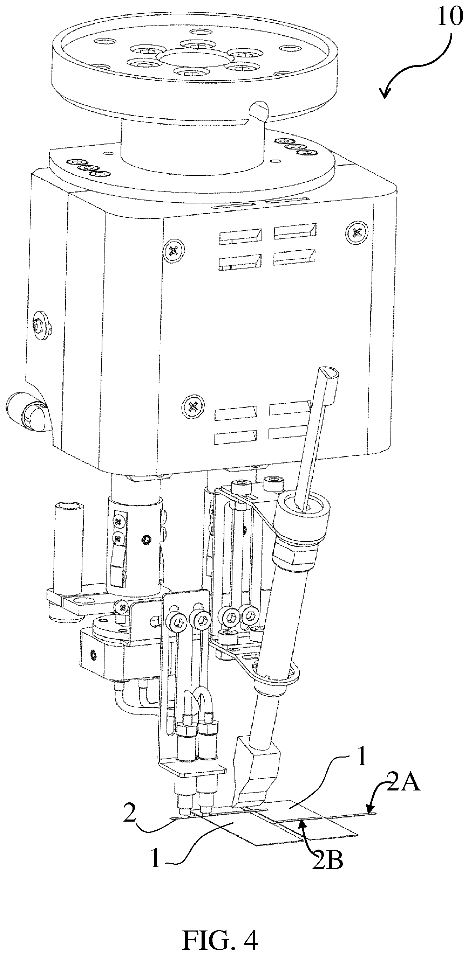

In particular, as shown in Figure 4, the electrical connector 2 consists of a free portion 2A, that is the portion arranged below the solar cell 1 during the realization of the string and able to be welded to the latter indirectly, and of a connecting portion 2B, that is the portion arranged above the solar cell 1 during the realization of the string and able to be welded to the latter directly.

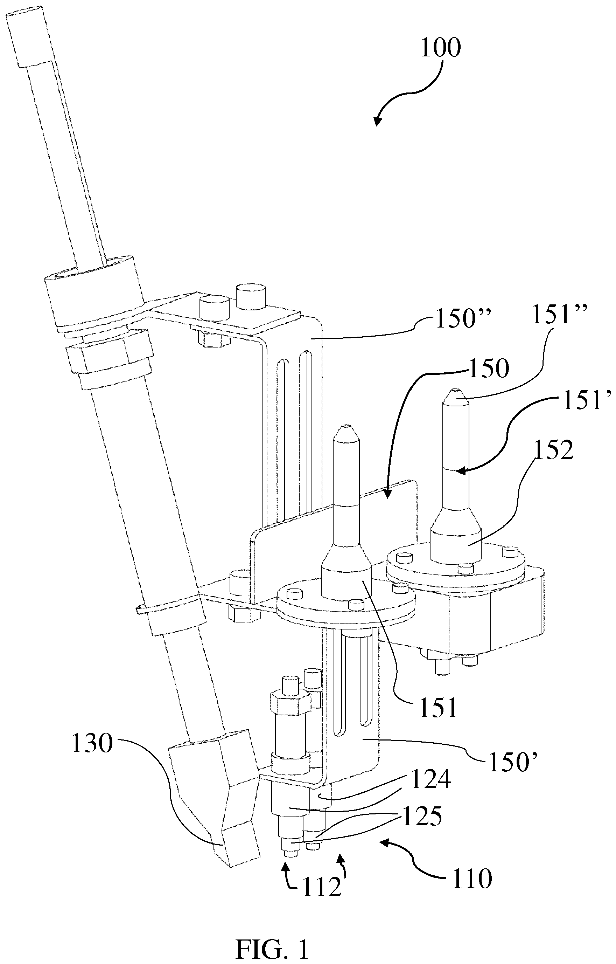

Figure 1 shows the device 100 for gripping and welding solar cells 1 with corresponding electrical connectors 2, according to the present invention. In particular, the embodiment illustrated in Figure 1 also includes the components designed for coupling with an interface device for coupling to an actuating head, according to what is described in detail below, which may not be present while maintaining the concept inventive.

The device 100 for gripping and welding according to the present invention comprises suction means 110 able to retain in use the solar cell 1 or the electrical connector 2, in relation to the step to be carried out for the definition of the solar cell string as hereinafter described in more detail. The suction means 110 define a gripping area (not shown) respectively of the solar cell 1 or of the electrical connector 2.

The term *"gripping area"* means, in the present invention, the area within which respectively the solar cell 1 or the electrical connector 2 are retained by the device 100 for gripping and retaining. In particular, in the present invention the term *"gripping area"* identifies the area within which the suction means 110 define their operation and, therefore, retaining area. The gripping area does not necessarily or exclusively correspond to a surface of the aforementioned device 100, or a component thereof. In fact, the gripping area is subjected to a portion of the device 100 only at the suction means 110, being otherwise extended on a hypothetical plane contiguous to the surface of the terminal portion of the aforementioned suction means 110, possibly as a function of the applied suction power. Thus, the gripping area is an area within which respectively the solar cell 1 or the electrical connector 2 are retained by the device 100 for gripping and actuating and at least partially in contact with the suction means 110 respectively.

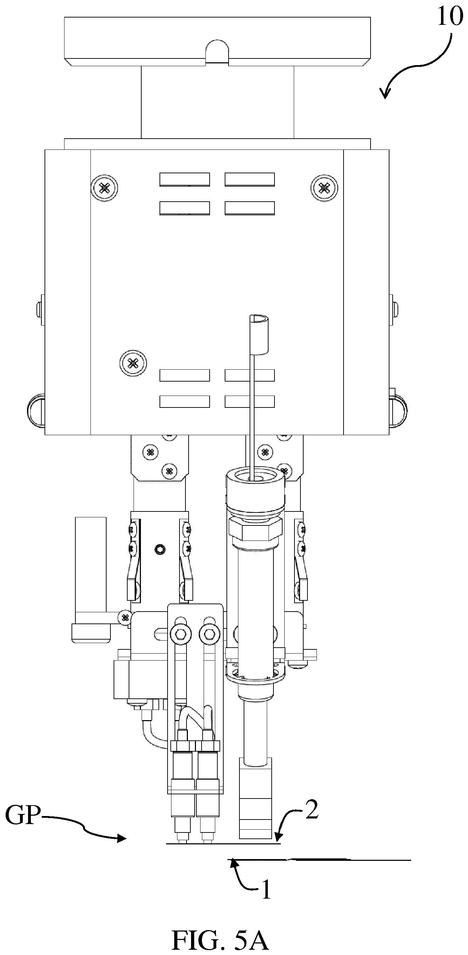

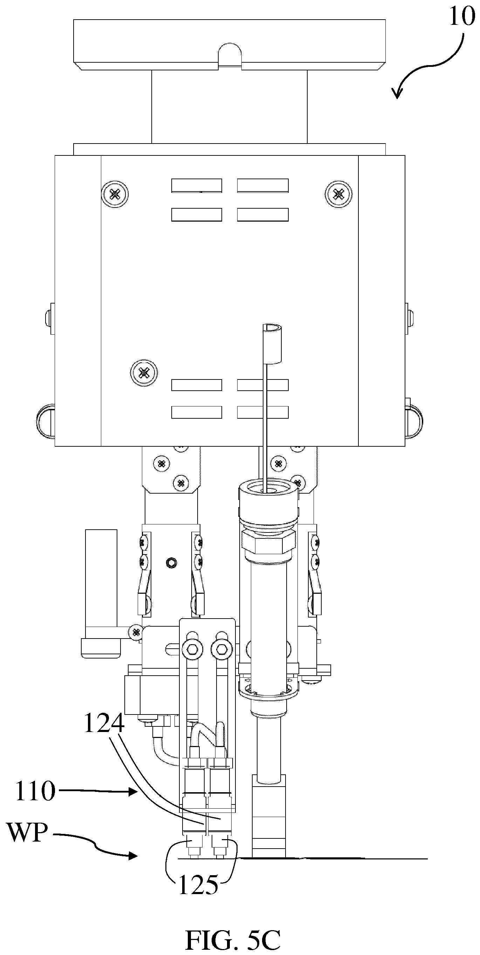

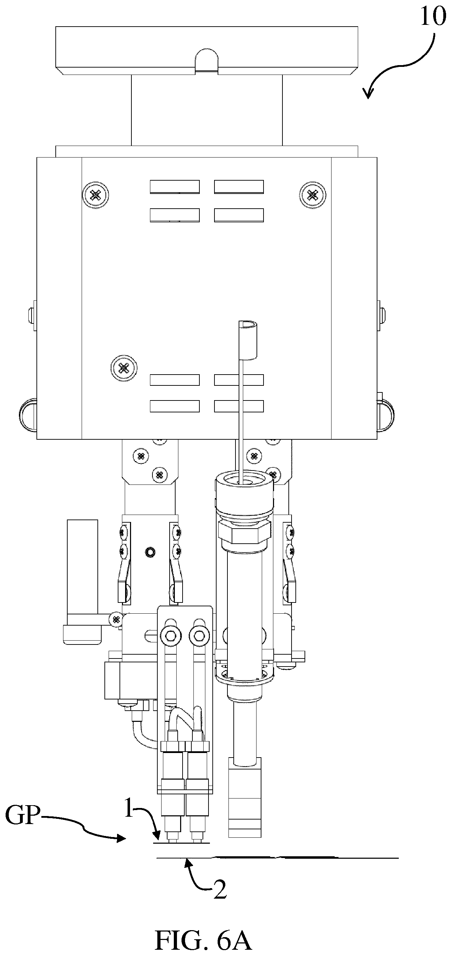

The suction means 110, described in greater detail below, can be movable with respect to the welding means 130, described in greater detail below, between two different positions, in particular between a gripping position GP and a welding position WP, and vice versa. In the gripping position GP, illustrated by way of example in Figures 5A and 6A, the suction means 110 retain the solar cell 1 or the electrical connector 2 spaced from the welding area defined by the aforementioned welding means 130. In the welding position WP, illustrated by way of example in Figure 5C, the suction means 110 retain the electrical connector 2 at the aforementioned welding area in contact with the welding means 130 during the melting of the welding layer of the electrical connector 2. Hence, the suction means 110 are of the movable type and, consequently, define a gripping area of the movable type according to the aforementioned displacements between the gripping position GP and the welding position WP, and vice versa.

The aforementioned device 100 is completed by suitable welding means 130 of the electrical connector 2 to the solar cell 1 and defining the aforementioned welding area. The welding means 130 are able to heat during use the welding area for melting the electrical connector 2.

The suction means 110 and the welding means 130 are aligned along an alignment axis parallel to the gripping area and to the welding area in the welding position WP. According to the present invention,

the end portions of the welding means 130 and the suction means 110 are aligned in the welding portion WP.

In the embodiment illustrated therein, the aforementioned welding means 130 comprise a welding tip which defines the aforementioned welding area, preferably electrically connected to a heating circuit (not shown). Further embodiments are however possible.

The welding means 130, i.e. the relative welding tip, has an arrangement which is spaced from the suction means 110 when the latter are arranged in the aforementioned gripping position GP. In this way, during the gripping of the solar cell 1 or of the electrical connector 2, the welding means 130 are not physically in contact with the aforementioned elements 1 and 2. Furthermore, the welding means 130, or the relative welding tip, are arranged outside the gripping area of the solar cell 1 or of the electrical connector 2. In this way, the welding tip 130 appears to be in contact only with the electrical connector 2 when the suction means 110 are in the welding position WP, preserving the solar cell 1 from any damage.

The suction means 110 consist of two suction ducts collectively numbered 112 in Figure 1, which define the aforesaid gripping area. The suction ducts 112 are configured to retain, in use, alternatively the solar cell 1 and the electrical connector 2, exerting a negative pressure thereon, i.e. applying a suction force.

The suction ducts 112 are aligned along the alignment axis According to the present invention, the suction ducts 112 and the welding tip 130 are aligned along said alignment axis and the welding tip 130 is arranged adjacent to said suction ducts 112.

Preferably, the aforementioned alignment axis is parallel to both a symmetry axis (not shown) of the gripping area, and a symmetry axis (not shown) of the welding area.

The aforementioned suction ducts 112 have the respective opening, defining the suction end, so as to be aligned on a single plane defining the gripping area. In particular, the gripping area is defined in such a way as to be parallel to the hypothetical welding area when the device 100 performs the welding of the electrical connector 2 on the solar cell 1. This can be ensured by the arrangement at the same distance from the hypothetical welding plane of each opening of the suction ducts 112. In the present embodiment, the gripping area does not correspond exclusively to the area occupied by the openings of the suction ducts 112 but is extended on a hypothetical plane contiguous to the surface underlying said openings and such as to retain the solar cell 1 or the electrical connector 2. Thus, the openings of the suction ducts 112 define, in part, the perimeter of the aforesaid gripping area.

The alignment of the suction ducts 112 and the welding tip 130, as described above, is such as to arrange the gripping area and the welding area on parallel planes, although different. This parallelism is preferably maintained during the steps of taking the solar cell 1 and the electrical connector 2, as well as during the welding steps of the aforementioned electrical connector 2 to the solar cell 1.

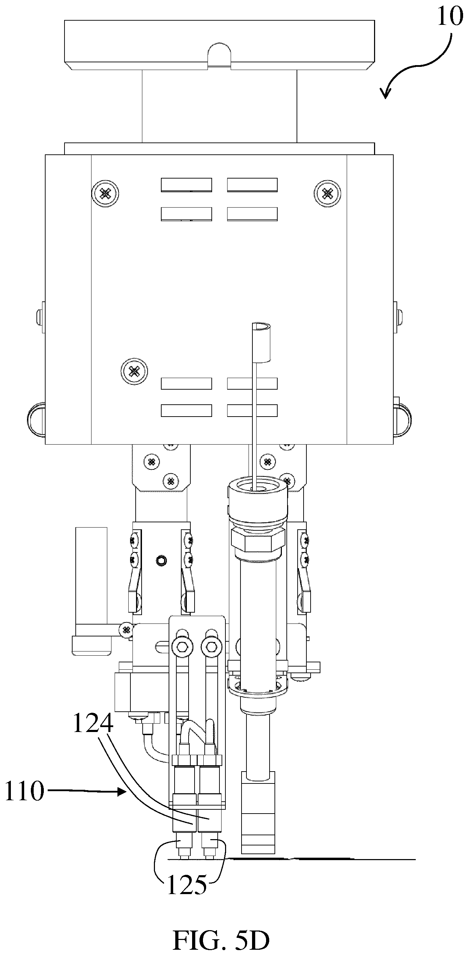

In the embodiment illustrated therein, the suction ducts 112 comprise two distinct and operatively connected portions. In particular, the suction ducts 112 comprise a fixed channel 124 and a movable portion 125, as illustrated by way of example in Figures 5C and 5D. The latter is defined by the terminal portion of the suction duct 112 which is in contact with the aforementioned solar cells 1 or electrical connectors 2 when in use during suction. This movable portion 125 is operatively connected to the fixed channel 124 so as to be movable, or slidable, within the latter and with respect to the position of the welding means 130.

Thus, each of the suction ducts 112 is operatively connected to suitable elastic means for moving the suction ducts 112 between the gripping position GP and the welding position WP, and vice versa. In particular, the aforesaid elastic means are interposed between the aforesaid fixed channels 124 and the aforesaid portions movable 125 to allow relative movement of the movable portions 125, according to the previous description. The elastic means are pre-tensioned to maintain the suction ducts 112, i.e. the relative mobile portions 125, in the gripping position GP and allow to arrange the suction ducts 112, or the corresponding mobile portions 125, in the welding position WP when the suction ducts 112, or the relative mobile portions 125, are subjected to pressure on a support, for example the support on which the string of solar cells is made.

In the present embodiment, the elastic means are made by a plurality of springs, preferably of the helical type, each provided with an end connected to the movable portion 125 and to the opposite end connected to the fixed channel 124. These are pre-tensioned in such a way that in their resting condition they dispose each suction duct 112 at the maximum axial extension with respect to the terminal portion of the device 100 for gripping and welding corresponding to the gripping position GP. During the deposition and welding step of the electrical connector 2, the springs are compressed due to the arrangement of the suction ducts 112 against the substrate which defines the hypothetical construction plane of the string of solar cells. The compression moves each suction duct 112 at the minimum axial extension with respect to the terminal portion of the device 100 for gripping and welding, corresponding to the welding position WP. The springs also allow the automatic return to the resting configuration corresponding to the gripping position GP, thanks to the action of the aforementioned pre-tensioning.

The term *"axial extension"* means, in the present invention, the extension along an axis orthogonal to the hypothetical welding plane. In the embodiment illustrated therein, this axis is aligned with the major extension of the device 100 for gripping and welding.

The welding tip 130 is preferably heated only when in contact with the electrical connector 2, that is when the suction means 130 are arranged in the aforementioned welding position WP. To obtain a correct welding it is important to determine the pressure that the welding tip 130 must exert on the electrical connector 2 and, consequently, on the solar cell 1 where it must be welded. For this reason, it is very important to determine exactly the pre-tensioning of the springs or, in general, of the elastic means in such a way that at the minimum axial extension the desired pressures are obtained. Alternatively, or in addition, it is possible to determine the desired pressure by moving the device 100 for gripping and welding only for a portion of the travel of the elastic means or to impart a greater pressure after reaching the minimum axial extension of the second suction means.

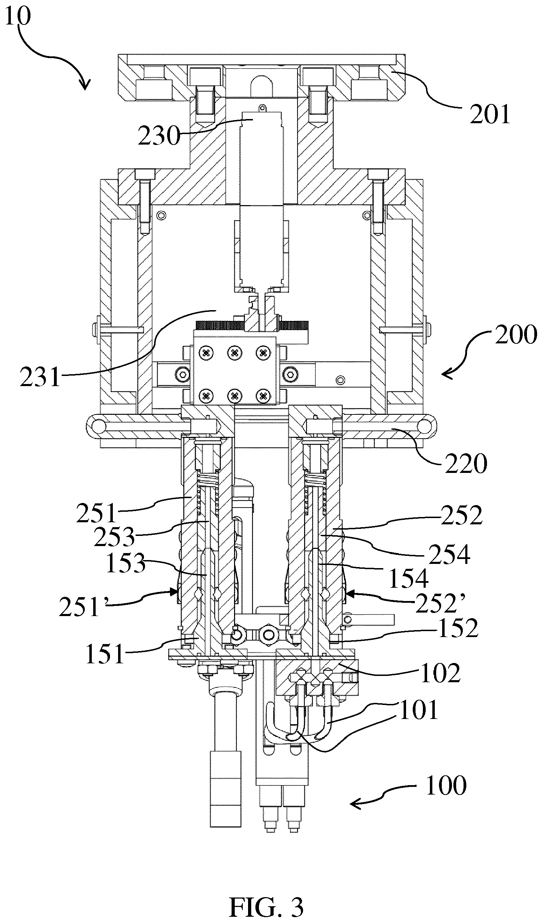

The suction force, or negative pressure, exerted by the suction ducts 112 is obtained by connecting each of these to a single suction fitting 101, illustrated by way of example in Figure 3. Each suction fitting 101 is successively connected to a single splitter device 102, illustrated again in the same Figure 3, which allows to reduce the costs and dimensions of the device 100 for gripping and welding, having the operating condition, i.e. in the suction step, at the same time both the suction ducts 112. Obviously, also the arrangement in the rest condition, or in the non-suction step, occurs simultaneously for both the suction ducts 112.

According to an alternative embodiment, not shown, each suction duct of the suction means is connected to its own suction fitting independently, i.e. without the use of a splitter device for feeding compressed air. In this case, the suction ducts can be arranged in operating condition, that is during the suction step, both simultaneously and separately, according to the operating requirements for which the device for gripping and welding is used. Also, the arrangement in the rest condition, that is not during the suction step, can be carried out simultaneously for both the suction ducts as well as separately, according to the operational requirements for which the device for gripping and welding is used.

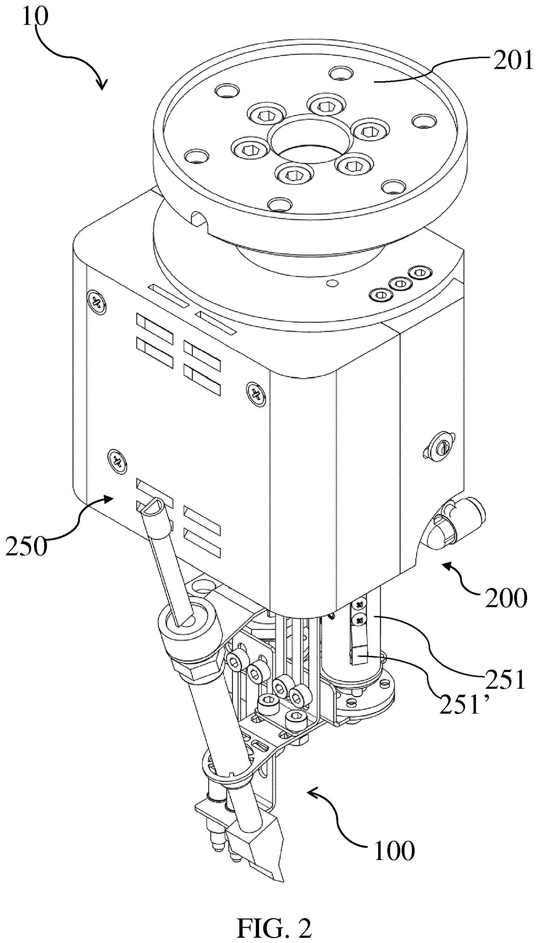

The device 100 for gripping and welding described above is able to be coupled to an interface device 200 for defining an actuating head 10 for the robotic arm for gripping and welding solar cells 2 with electrical connectors 1. Figures 2 and 3 illustrate an embodiment of the aforesaid actuating head 10 and the related interface device 200, described hereinafter in greater detail.

Figure 1 illustrates the device 100 for gripping and welding as previously described and further provided with the components necessary for the coupling with the aforesaid actuating head 10. In particular, the device 100 for gripping and welding illustrated in the embodiment of Figure 1 comprises a first mechanical interface pin 151 and a second mechanical interface pin 152.

According to further embodiments, not illustrated, the number of mechanical interface pins of the device for gripping and welding can vary and comprises at least one first mechanical interface pin.

The pair of mechanical interface pins 151, 152 allows to realize the mechanical connection between the device 100 and the interface 200, thus constituting the actuating head 10. In the aforesaid embodiment, the pins 151, 152 define the end of the device 100 for gripping and welding to be connected to the actuating head 10 and are on a frame 150 for supporting the device 100 for gripping and welding.

As illustrated in Figure 1, the device 100 for gripping and welding is provided with a support frame 150 both for the suction means 110 and for the welding means 130. Furthermore, the aforesaid support frame 150 defines a support plane for the aforesaid mechanical interface pins 151, 152. Furthermore, the device 100 is provided with positioning means, shown in Figure 1, of the aforementioned suction means 110 and the aforementioned welding means 130 to the support frame 150.

In the embodiment illustrated in Figure 1, the positioning means comprise a first support bracket 150', able to operatively connect the suction means 110 to the support frame 150, and a second support bracket 150" able to operatively connect the welding means 130 to the support frame 150.

Moreover, the positioning means are able to allow the relative movement of said suction means 110 and/or the welding means 130 with respect to the support frame 150 to modify the positioning of the gripping area with respect to the welding area in the gripping position GP. In particular, the suction means 110 and the welding means 130 are able to move, respectively to said first support bracket 150' and said second support bracket 150", along a direction perpendicular to the alignment axis.

The end of the device 100 defined by the aforementioned pins 151, 152 is therefore connected to the welding means 130 and to the suction means 110 by means of the aforementioned support frame 150, interposed between them.

Preferably, the aforesaid pins 151, 152 have a cylindrical section with a tapered end portion 151", 152" to facilitate the coupling with an interface device 200 for defining an actuating head 10, described in greater detail in the following. Furthermore, the pair of mechanical interface pins 151, 152 has a central groove 151', 152' to facilitate locking of the aforementioned coupling.

The mechanical interface pins 151, 152 further have a through-opening 153, 154 (shown in section in Figure 3) that allows the suction means 110 to be fed, integrating into a single element, i.e. the single interface pin 151, 152, both the mechanical connection and the pneumatic connection. This favours the rapidity of replacement of the device 100 for gripping and welding since connecting and disconnecting the mechanical interface pins 151, 152 is automatically realized or interrupted by both the mechanical coupling and the pneumatic coupling. Therefore, the through-openings 153, 154 define a portion of an air duct from which further flexible ducts, operatively connected with the suction means, may depart. In particular, in the embodiment illustrated therein, the duct defined by the through-opening 153 is closed at the bottom while the duct defined by the through-opening 154 for feeding said suction means 110 is used.

The interface device 200 is illustrated as integrated in the assembly of the actuating head 10 of Figures 2 and 3. This interface device 200 makes it possible to make the operative connection to the device 100 for gripping and welding and to a possible robotic arm (not shown) able to move the aforesaid actuating head 10. The interface device 200 comprises a first mechanical interface connector 251 and a second mechanical interface connector 252.

Also, in this case, according to further embodiments, not shown, the number of mechanical interface connectors of the interface device can vary and comprises at least one first mechanical interface pin.

The pair of mechanical interface connectors 251, 252 is able to couple with the respective mechanical interface pins 151, 152 of the device 100 for gripping and welding described previously.

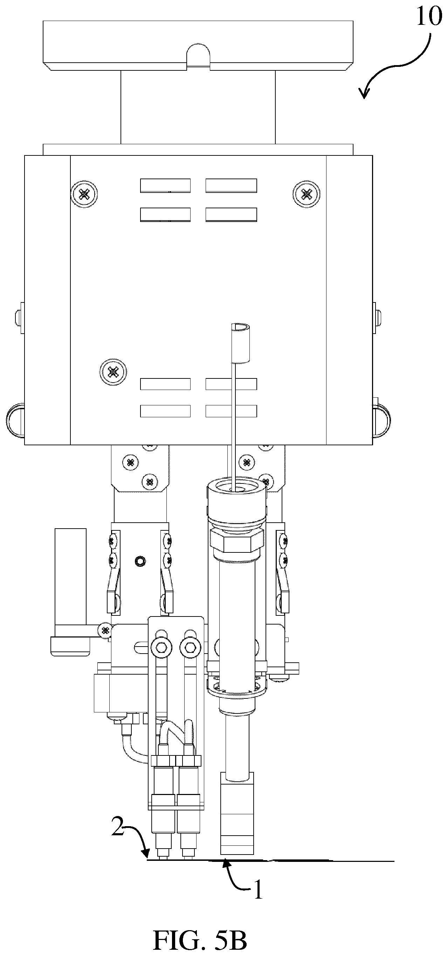

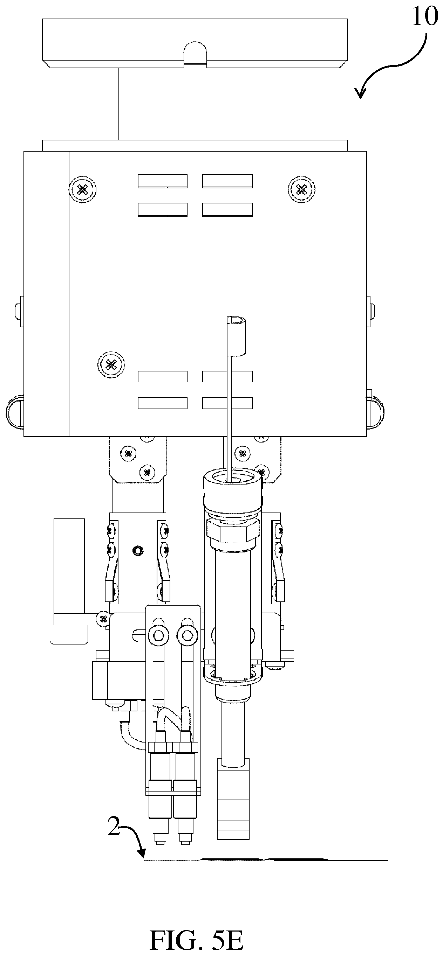

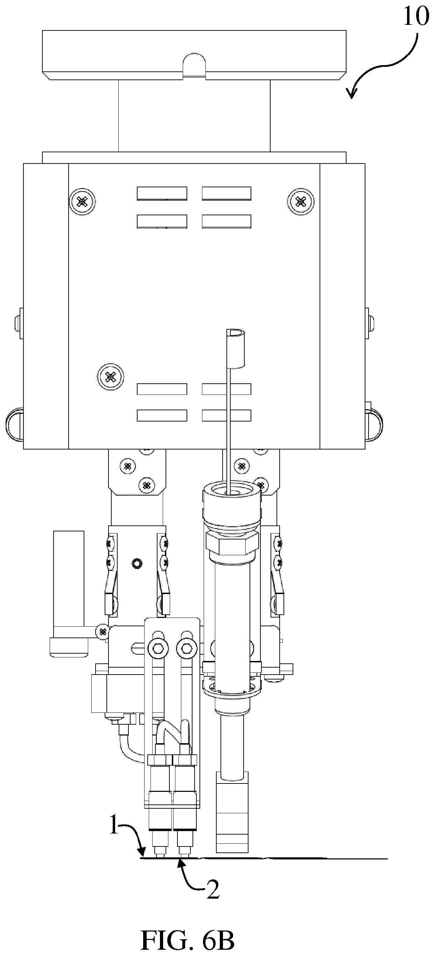

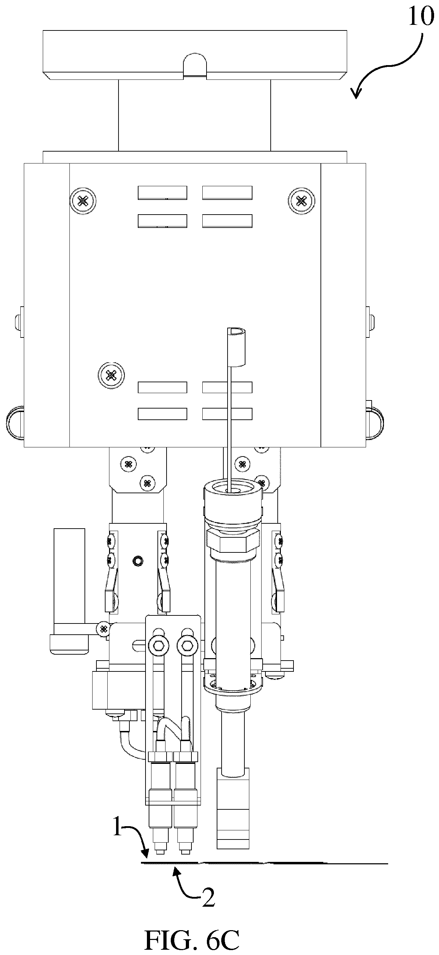

In the embodiment illustrated in Figures 5 and 6, the connectors 251, 252 define the end of the interface device 200 to be connected to the device 100 for gripping and welding and are disposed at the opposite end defined by the coupling flange 201 with a robotic arm (not shown).

Preferably, the aforesaid connectors 251, 252 have a cylindrical section with a bevelled end portion to facilitate insertion of the tapered end portion 151",152" of the corresponding pins 151, 152. Further, the pair of mechanical interface connectors 251, 252 is provided with suitable locking means 251', 252' able to retain the mechanical interface pins 151, 152 in the correct locking position. This locking position corresponds, in particular, to the position in which the coupling between the central groove 151', 152' of the pins 151, 152 and a seal of the O-ring type provided on the connectors 251, 252 and such as to obtain the pneumatic seal.

Thus, the first mechanical interface connector 251 and/or the second mechanical interface connector 252 can be implemented between an operating position, in which the latter are respectively coupled to the first mechanical interface pin 151 and/or to the second mechanical interface pin 152, and a resting position, wherein these are respectively decoupled from the first mechanical interface pin 151 and/or from the second mechanical interface pin 152. In particular, the interface device 200 comprises an electric motor 230 operatively connected to the first mechanical interface connector 251 and/or to the second mechanical interface connector 252 for modifying the mutual distance between said first connector and said second connector, as described below in more detail.

Analogously to what has been described for the aforesaid mechanical interface pins 151, 152, the mechanical interface connectors 251, 252 also have a through-opening 253, 254 (shown in section in Figure 3) for the pneumatic supply of the aforesaid pins 151, 152. This structure favours the quick replacement of the device 100 for gripping and welding with the automatic and simultaneous realization or interruption of the mechanical coupling and of the pneumatic coupling. Each pin-connector connection therefore produces a suction connection which can be operatively connected to the suction means. In the embodiment illustrated therein, the pin-connector connection 152, 252 is operatively connected to the suction means 110 and further operatively connected to suitable pneumatic means for feeding the aforementioned suction means. In particular, the mechanical interface pin 152 and the mechanical interface connector 252 have respective through-openings 154, 254 which define, when coupled, an air duct for feeding the suction means 110. The specular pin-connector coupling 151, 251, although defining a duct with respect to the respective through-openings 153, 253 is not connected to the suction means 110.

Preferably, moreover, the interface device 200 comprises compressed air feeding means 220 (shown partially in the form of a duct in Figure 3) and at least one Venturi device, operatively connected to the aforesaid compressed air feeding means 220 and, accordingly, to the suction means 110. The Venturi device enables suction power to be obtained from the aforementioned suction means 110 by feeding compressed air in the Venturi device itself.

In the present invention, the term *"Venturi device"* means a device capable of generating negative pressure from the feed of a positive-pressure fluid. Such a device is, for example, provided with an inlet end and an outlet end for feeding a positive pressure fluid between which a narrowing is interposed at which a duct able to generate suction force is arranged, i.e. negative pressure, at the passage of said positive-pressure fluid.

As illustrated in Figure 3, the end of the interface device 200 defined by the aforementioned pins 251, 252 is disposed at the opposite end provided with the interface flange 201. A containment body 250 is interposed between said ends and is able to contain one or more elements of the actuating head 10 or a part thereof. For example, the interface device 200 comprises a control unit (not shown), preferably disposed inside said containment body 250. Such a control unit houses the electric motor 230 and is operatively connected to the previously described first interface connector 251 and/or second interface connector 252 by means of a rack 231, also disposed within the containment structure 250. In order to maintain the required work environment safety, the electric motor 230 is of the low voltage type, preferably 24V powered. On the electric motor 230 a position encoder is installed, which advantageously makes it possible to determine with high precision the angle of rotation of its shaft, and/or its speed of rotation. In detail, the rotation of the electric motor 230 determines the axial displacement of the rack 231 and the consequent movement towards or away from of one or both of the mechanical interface connectors 251, 252. Clearance recovery means can also be present, comprising preferably but in a non-limiting way a compensating spring.

According to a further embodiment, not illustrated, the interface device may be provided with a pair of racks in order to ensure symmetry of movement of both the mechanical interface connectors.

The handling of the mechanical interface connectors 251, 252 advantageously allows to adjust the pitch between these and the associated mechanical interface pins 151, 252, or to modify the mutual distance between said first connector and said second connector as a function of the reciprocal distance between the first mechanical interface pin and the second mechanical interface pin. In this way, it is possible to obtain a high degree of flexibility in terms of connection capacity with different devices for gripping and welding provided with mechanical interface pins with different mutual spacings, adapting the actuating head to the requirements determined by the type of application or components to be moved and welded. The pitch adaptation can be advantageously carried out through an automatic procedure by using the position encoder installed on the electric motor 230.

The actuating head 10 for gripping and welding solar cells 1 and electrical connectors 2 described above is able to be coupled to a robotic arm (not shown), provided with an end comprising a housing flange for connection to the aforementioned. coupling flange 201, defining a robot for gripping and welding solar cells with relative electrical connectors for the construction of a string of solar cells. Preferably, the robot for gripping and welding further comprises a computerized and programmable data processing unit (not shown) able to control the movement of the robotic arm and/or of the actuating head 10 for gripping and welding and/or the device 100 for gripping and welding. Preferably, this data processing unit is able to control the control unit of the interface device 200 for actuating the welding means 130 of the device 100 for gripping and welding. Even more preferably, the aforesaid data processing unit can determine the movement of the actuating head 10 along a first axis, perpendicular to the lying plane and/or to the welding plane of the electrical connector 2 on the solar cell 1. Further, the data processing unit can determine the movement of the aforesaid actuating head 10 also along a second axis, parallel to the aforesaid lying and welding planes, in a movement that can also be composed with the movement along the first axis.

Through the previously described device 100 for gripping and welding, object of the present invention, it is possible to realize a method for gripping and welding solar cells 1 to respective electrical connectors 2 for the realization of a string of solar cells, as described below, but not being part of the present invention. The same process steps can also be carried out when the aforementioned device 100 for gripping and welding is an integral part of an actuating head 10 for gripping and welding and/or when the same is an integral part of a robot for gripping and welding.

Advantageously, the use of a device 100 for gripping and welding according to the present invention allows to obtain an optimum and homogeneous welding precision, avoiding the risks connected with anomalous movement of the solar cell 1 or of the electrical connector 2 itself, as well as any welds which they can generate significant resistivity variations in the solar cell-electrical connector coupling.

The aforesaid method for gripping and welding solar cells 1 and related electrical connectors 2 for producing a string of solar cells comprises the steps described below, preferably in the identified sequence. It is hypothesized that the solar cell 1 and the electrical connector 2 are arranged on the same lying plane in two different locations, for example a store (plane or vertical) of solar cells 1 and a store (plane or vertical) of electrical connectors 2. Preferably, the electrical connector 2 is of the strip-type, as described above. The realization of the string of solar cells is therefore obtained by coupling, or welding, in series a plurality of solar cells 1 by using the aforesaid electrical connectors 2.

In a first step, illustrated in Figure 6A, the solar cell 1 is taken within a gripping area by means of the first suction means 110. The solar cell 1 is withdrawn by arranging the aforementioned suction means 110, i.e. the gripping area, at the solar cells 1 store or at a location thereof defining a first gripping position. The collected solar cell 1 is, therefore, retained within the gripping area, continuing with the subsequent steps. The collection and retention of the solar cell 1 within the aforesaid gripping area is achieved by generating and using negative pressure, or suction, by means of the first suction means 110, advantageously by using both suction ducts 112 described previously. The activation of the suction ducts 112 is preferably obtained simultaneously to ensure optimal adhesion of the solar cell 1 to the defined gripping area.

During the step of retaining the solar cell 1, this is arranged in the gripping position GP spaced away from the welding means.

Subsequently, a step of arranging the solar cell 1 at a support allows the solar cell 1 to be moved from its store location to its welding location, while maintaining the retention of the solar cell 1. This makes it possible to correctly orient the solar cell 1 with respect to the position required on the substrate, for example with respect to an electrical connector 2 already present or with respect to further solar cells 1 already deposited and welded in the solar cell string portion.

The device 10 is thus moved for the step of releasing the solar cell 1 on the support, as illustrated in Figure 6B. During this step, the suction means 110 can maintain their position spaced from the welding means 130 since the latter must not be used for welding.

Finally, in a further step of releasing the solar cell 1, illustrated in Figure 6C, the suction means 110 are moved away from the solar cell 1 released after having interrupted the supply of negative pressure at the gripping area.

The device 100 for gripping and welding can then be moved again to remove the electrical connector 2.

Thus, in a subsequent step, illustrated in Figure 5A, a strip-type electrical connector 2 is taken within the same gripping area defined by the suction means 110. The electrical connector 2 is withdrawn by arranging the aforementioned suction means, or the gripping area, at the electrical connectors 2 store or at a location thereof defining a second gripping position. The collected electrical connector 2 is, therefore, retained within the gripping area, continuing with the subsequent steps. The collection and retention of the electrical connector 2 within the aforesaid gripping area is achieved by generating and using negative pressure, or suction, by means of the suction means 110, as described previously. In particular, also the electrical connector 2 is arranged in the gripping position GP spaced from the welding means 130, as described previously.

Subsequently, a step of arranging the electrical connector 2 at a support and at least partially above the previously released solar cell 1 allows the electrical connector 2 to be moved from its store location to its welding location, while maintaining it anyway. This step is illustrated in Figure 5B. This makes it possible to correctly orient the electrical connector 2 with respect to the welding position on the previously released solar cell 1, for example by placing the aforementioned electrical connector 2 in the centre of the deposited solar cell 1 or at a portion thereof for coupling by welding.

The suction means 110 are thus moved for the step of depositing the electrical connector 2 in the welding position WP from the preceding gripping position GP, as illustrated in Figure 5C. This allows contacting the electrical connector 2 on the substrate and at least partially on the solar cell 1 on which it will be welded. In particular, a free portion 2A of the electrical connector 2 is arranged on the support and a portion 2B for connecting the electrical connector 2 is arranged in contact with the solar cell 1, the aforesaid electric connector 2 being however retained by the suction means 110

To allow movement between the gripping position GP at the welding position WP of the electrical connector 2 to the solar cell 1, the device 100 for gripping and welding is pressed against the surface of the substrate, exploiting the elastic means for obtaining the movement of the welding means 110.

Following the deposition, the step of welding the electrical connector 2 to the solar cell 1 is performed by means of suitable welding means 130 able to heat the welding area for the fusion of the connecting portion 2B of the electrical connector 2. The welding step is carried out by exerting a predetermined pressure of the electrical connector 2 on the solar cell 1, in order to obtain a correct welding avoiding damage to the solar cell 1 itself. For this reason, it is necessary to accurately determine the pre-tensioning value of the springs or, in general, of the elastic means in such a way that the desired pressures are obtained at the minimum axial extension.

When welding is completed, the suction means 110 is then moved to reposition from the welding position WP to the previous gripping position GP, as illustrated in Figure 5D.

Finally, one last step consists in releasing the electrical connector 2 coupled to the solar cell 1. At this point, by eliminating the effect of the negative pressure applied through the suction ducts 112, the electrical connector 2 is released by terminating the application thereof, as illustrated in Figure 5E.

The device 100 for gripping and welding can then be moved again to start a new cycle with the step of collecting and retaining a new solar cell 1, preferably from the aforementioned first gripping position of the relative store. In particular, the above steps can be repeated by arranging further solar cells 1 on the support in a position adjacent to the preceding solar cell 1, or by arranging the successive solar cells side by side along the development direction of the string of solar cells. Further, the further moving solar cells are also arranged above the free portion of the electrical connector of the preceding solar cell, until the desired solar cell string is completed. In this case, the problem of welding the free portions 2A, arranged under the solar cell 1 adjacent to the solar cell already deposited, also arises. Therefore, the step of welding the electrical connector 2 to the solar cell 1 by welding the connecting portion 2B of the electrical connector 2 on the solar cell 1 simultaneously achieves the welding of the free portion 2A of the preceding electrical connector 2 arranged below the solar cell 1 to be welded.

The control of the movement of the device 100 for gripping and welding and/or of the actuating head 10 of which the aforementioned device 100 is part can be performed by a data processing unit, for example the data processing unit of a robot, which performs a stored process according to appropriate instructions in suitable storage means, preferably of the non-volatile type. For example, the method described above could be coded as a sequence of instructions inside a data processing unit.

The device for gripping and welding can be made for the dimensions of a specific solar cell 1 and of a corresponding specific electrical connector 2. Therefore, a plurality of devices for gripping and welding can be made according to the applications to be implemented. In this case, the coupling of one of the devices for gripping and welding with the interface device for the realization of an actuating head for gripping and welding is obtained, as described previously, by means of the coupling between the mechanical interface pins and mechanical interface connectors, in which the connectors provided on the interface device can be moved axially with respect to the aforementioned pins. This, advantageously, allows to adapt the differences in pitch that may exist between different interface pins and therefore allows the actuating head to work with a high flexibility in terms of connection capacity with different gripping devices. The adaptation of the pitch is advantageously carried out through an automatic procedure thanks to the presence of the position encoder installed on the electric motor. In particular, this automatic procedure is performed upstream of the first step described above for the method.

## Claims

1. A Device (100) for gripping and welding solar cells (1) with corresponding electrical connector (2) for the construction of a string of solar cells, comprising:
- suction means (110) able to hold during use the solar cell (1) or the electrical connector (2) and defining a gripping area of said solar cell (1) or of said electrical connector (2);
- welding means (130) of said electrical connector (2) to said solar cell (1) and defining a welding area of said electrical connector (2), able to heat during use said welding area for melting said electrical connector (2);
and being **characterised in that**:
said suction means (110) are movable with respect to said welding means (130) between a gripping position (GP), wherein said suction means (110) retain said solar cell (1) or said electrical connector (2) spaced from said welding area, and a welding position (WP), wherein said suction means (110) retain said electrical connector (2) at said welding area in contact with said welding means (130) during the melting of the welding layer of said electrical connector (2), and
wherein said suction means (110) and said welding means (130) are aligned along an alignment axis parallel to said gripping area and to said welding area in said welding position (WP);
wherein said suction means (110) consist of two suction ducts (112) aligned along said alignment axis,
wherein said device (100) for gripping and welding comprises elastic means operatively connected to said suction ducts (112) for moving said suction ducts (112) between said gripping position (GP) and said welding position (WP), and vice versa,
wherein said elastic means are pre-tensioned to keep said suction ducts (112) in said gripping position (GP) and allow said suction ducts (112) to be arranged in said welding position (WP) when said suction ducts (112) are subjected to pressure on a support,
wherein said welding means (130) comprise a welding tip which defines said welding area,
wherein said suction ducts (112) and said welding tip are aligned along said alignment axis in said welding position (WP), and
wherein said welding tip is arranged side by side with said suction ducts (112).

2. The device (100) for gripping and welding according to claim 1, comprising a support frame (150) and positioning means of said suction means (110) and of said welding means (130) to said support frame (150), wherein said positioning means are able to allow the relative movement of said suction means (110) and said welding means (130) with respect to said support frame (150) to modify the positioning of said gripping area with respect to said welding area in said gripping position (GP).

3. The device (100) for gripping and welding according to claim 2, wherein said positioning means comprise a first support bracket (150'), able to operatively connect said suction means (110) to said support frame (150), and a second support bracket (150"), able to operatively connect said welding means (130) to said support frame (150),
wherein said suction means (110) and said welding means (130) are able to move, respectively to said first support bracket (150') and said second support bracket (150"), along a direction perpendicular to said alignment axis.

4. An actuating head (10) for a robotic arm for gripping and welding solar cells with corresponding electrical connectors for the construction of a string of solar cells, comprising:
- a device (100) for gripping and welding solar cells (1) with corresponding electrical connectors (2) for the realization of a string of solar cells, according to one or more claims from 1 to 3;
- an interface device (200) provided with a coupling flange (201) for said robotic arm and able to operatively connecting said device (100) for gripping and welding to said robotic arm;
wherein said device (100) for gripping and welding comprises at least a first mechanical interface pin (151),
wherein said interface device (200) comprises at least a first mechanical interface connector (251) able to mate with said first mechanical interface pin (151),
wherein said first mechanical interface pin (151) and said first mechanical interface connector (251) respectively have a through-opening (153, 253) which defines, when coupled, a first air duct for feeding said suction means (110).

5. The actuating head (10) for gripping and welding according to claim 4, wherein said interface device (200) comprises compressed air feeding means (220) and at least one Venturi device, operatively connected to said compressed air feeding means (220) and to said suction means (110), to obtain suction force to said suction means (110) through the feeding of compressed air into the Venturi device.

6. The actuating head (10) for gripping and welding according to claim 4 or 5, wherein said device (100) for gripping and welding comprises a first mechanical interface pin (151) and a second mechanical interface pin (152),
wherein said interface device (200) comprises a first mechanical interface connector (251) and a second mechanical interface connector (252), wherein said first mechanical interface connector (251) and/or said second mechanical interface connector (252) are actuatable between an operating position, wherein said first mechanical interface connector (251) and/or said second mechanical interface connector (252) are respectively coupled to said first mechanical interface pin (151) and/or to said second mechanical interface pin (152), and a resting position, wherein said first mechanical interface connector (251) and/or said second mechanical interface connector (252) are respectively decoupled from said first mechanical interface pin (151) and/or from said second mechanical interface pin (152),
wherein said interface device (200) comprises an electric motor operatively connected to said first mechanical interface connector (251) and/or said second mechanical interface connector (252) to modify the mutual distance between said first connector (251) and said second mechanical interface connector (252).

7. A robot for gripping and welding solar cells with corresponding electrical connectors for the realization of a string of solar cells in accord, comprising:
- an actuating head (10) for gripping and welding solar cells (1) with respective electrical connectors (2), according to one or more claims from 4 to 6;
- a robotic arm provided with an end comprising a housing flange for said coupling flange (201);
- a computerized and programmable data processing unit able to control the movement of said robotic arm and/or of said actuating head (10) for gripping and welding;
wherein said data processing unit is able to control said control unit of said interface device (200) for actuating said welding means (130) of said device (100) for gripping and welding.

## Patentansprüche

1. Vorrichtung (100) zum Greifen und Schweißen von Solarzellen (1) mit entsprechendem elektrischen Anschluss (2) für den Aufbau eines Strangs von Solarzellen, umfassend:
- Saugvorrichtung (110), die in der Lage ist, während der Verwendung die Solarzelle (1) oder den elektrischen Anschluss (2) zu halten und einen Greifbereich der Solarzelle (1) oder des elektrischen Anschlusses (2) zu definieren;
- Schweißvorrichtung (130) des elektrischen Anschlusses (2) an der Solarzelle (1) und Definieren eines Schweißbereichs des elektrischen Anschlusses (2), die in der Lage ist, während der Verwendung den Schweißbereich zum Schmelzen des elektrischen Anschlusses (2) zu erhitzen;
und **dadurch gekennzeichnet ist, dass**:
die Saugvorrichtung (110) in Bezug auf die Schweißvorrichtung (130) zwischen einer Greifposition (GP), in der die Saugvorrichtung (110) die Solarzelle (1) oder den elektrischen Anschluss (2) vom Schweißbereich beabstandet hält, und in einer Schweißposition (WP) bewegbar ist, in der die Saugvorrichtung (110) den elektrischen Anschluss (2) während des Schmelzens der Schweißschicht des elektrischen Anschlusses (2) am Schweißbereich in Kontakt mit der Schweißvorrichtung (130) hält, und
wobei die Saugvorrichtung (110) und die Schweißvorrichtung (130) entlang einer Ausrichtungsachse parallel zum Greifbereich und zum Schweißbereich in der Schweißposition (WP) ausgerichtet sind;
wobei die Saugvorrichtung (110) aus zwei Saugkanälen (112) besteht, die entlang der Ausrichtungsachse ausgerichtet sind,
wobei die Vorrichtung (100) zum Greifen und Schweißen eine elastische Vorrichtung umfasst, die betriebsmäßig mit den Saugkanälen (112) verbunden ist, um die Saugkanäle (112) zwischen der Greifposition (GP) und der Schweißposition (WP) und umgekehrt zu bewegen,
wobei die elastische Vorrichtung vorgespannt ist, um die Saugkanäle (112) in der Greifposition (GP) zu halten und es den Saugkanälen (112) zu ermöglicht, in der Schweißposition (WP) angeordnet zu werden, wenn die Saugkanäle (112) einem Druck auf eine Stütze ausgesetzt sind,
wobei die Schweißvorrichtung (130) eine Schweißdüse umfasst, die den Schweißbereich definiert,
wobei die Saugkanäle (112) und die Schweißdüse entlang der Ausrichtungsachse in der Schweißposition (WP) ausgerichtet sind, und
wobei die Schweißdüse Seite an Seite mit den Saugkanälen (112) angeordnet ist.

2. Vorrichtung (100) zum Greifen und Schweißen gemäß Anspruch 1, umfassend einen Tragrahmen (150) und eine Positionierungsvorrichtung der Saugvorrichtung (110) und der Schweißvorrichtung (130) am Tragrahmen (150), wobei die Positionierungsvorrichtung in der Lage ist, die relative Bewegung der Saugvorrichtung (110) und der Schweißvorrichtung (130) in Bezug auf den Tragrahmen (150) zu ermöglichen, um die Positionierung des Greifbereichs in Bezug auf den Schweißbereich in der Greifposition (GP) zu verändern.

3. Vorrichtung (100) zum Greifen und Schweißen gemäß Anspruch 2, wobei die Positionierungsvorrichtung eine erste Stützhalterung (150') umfasst, die in der Lage ist, die Saugvorrichtung (110) mit dem Tragrahmen (150) operativ zu verbinden, und eine zweite Stützhalterung (150"), die in der Lage ist, die Schweißvorrichtung (130) mit dem Tragrahmen (150) operativ zu verbinden,
wobei die Saugvorrichtung (110) und die Schweißvorrichtung (130) in der Lage sind, sich entlang einer Richtung senkrecht zu der Ausrichtungsachse zu bewegen, und zwar jeweils zu der ersten Stützhalterung (150') und der zweiten Stützhalterung (150").

4. Stellantrieb (10) für einen Roboterarm zum Greifen und Verschweißen von Solarzellen mit entsprechenden elektrischen Anschlüssen zur Realisierung eines Strangs von Solarzellen, umfassend:
- eine Vorrichtung (100) zum Greifen und Verschweißen von Solarzellen (1) mit entsprechenden elektrischen Anschlüssen (2) zur Realisierung eines Strangs von Solarzellen, gemäß einem oder mehreren der Ansprüche 1 bis 3;
- eine Schnittstellenvorrichtung (200), die mit einem Kupplungsflansch (201) für den Roboterarm versehen ist und in der Lage ist, die Vorrichtung (100) zum Greifen und Schweißen mit dem Roboterarm operativ zu verbinden;
wobei die Vorrichtung (100) zum Greifen und Schweißen mindestens einen ersten mechanischen Schnittstellenstift (151) umfasst,
wobei die Schnittstellenvorrichtung (200) mindestens einen ersten mechanischen Schnittstellenanschluss (251) umfasst, der mit dem ersten mechanischen Schnittstellenstift (151) ineinandergreifen kann, wobei der erste mechanische Schnittstellenstift (151) und der erste mechanische Schnittstellenanschluss (251) jeweils eine Durchgangsöffnung (153, 253) aufweisen, die, wenn sie gekoppelt sind, einen ersten Luftkanal zum Zuführen der Saugvorrichtung (110) definieren.

5. Stellantrieb (10) zum Greifen und Schweißen gemäß Anspruch 4, wobei die Schnittstellenvorrichtung (200) eine Druckluftzufuhrvorrichtung (220) und mindestens eine Venturi-Vorrichtung umfasst, die betriebsmäßig mit der Druckluftzufuhrvorrichtung (220) und der Saugvorrichtung (110) verbunden ist, um eine Saugkraft an der Saugvorrichtung (110) durch die Zufuhr von Druckluft in die Venturi-Vorrichtung zu erzielen.

6. Stellantrieb (10) zum Greifen und Schweißen gemäß Anspruch 4 oder 5, wobei die Vorrichtung (100) zum Greifen und Schweißen einen ersten mechanischen Schnittstellenstift (151) und einen zweiten mechanischen Schnittstellenstift (152) umfasst,
wobei die Schnittstellenvorrichtung (200) einen ersten mechanischen Schnittstellenanschluss (251) und einen zweiten mechanischen Schnittstellenanschluss (252) umfasst,
wobei der erste mechanische Schnittstellenanschluss (251) und/oder der zweite mechanische Schnittstellenanschluss (252) zwischen einer Betriebsposition, in der der erste mechanische Schnittstellenanschluss (251) und/oder der zweite mechanische Schnittstellenanschluss (252) jeweils mit dem ersten mechanischen Schnittstellenstift (151) und/oder dem zweiten mechanischen Schnittstellenstift (152) gekoppelt sind, und einer Arretierungsposition, in der der erste mechanische Schnittstellenanschluss (251) und/oder der zweite mechanische Schnittstellenanschluss (252) jeweils von dem ersten mechanischen Schnittstellenstift (151) und/oder dem zweiten mechanischen Schnittstellenstift (152) entkoppelt sind, betätigbar sind,
wobei die Schnittstellenvorrichtung (200) einen Elektromotor umfasst, der betriebsmäßig mit dem ersten mechanischen Schnittstellenanschluss (251) und/oder dem zweiten mechanischen Schnittstellenanschluss (252) verbunden ist, um den gegenseitigen Abstand zwischen dem ersten Anschluss (251) und dem zweiten mechanischen Schnittstellenanschluss (252) zu verändern.

7. Roboter zum Greifen und Verschweißen von Solarzellen mit entsprechenden elektrischen Anschlüssen zur Realisierung eines Strangs von Solarzellen im Verbund, umfassend:
- einen Stellantrieb (10) zum Greifen und Schweißen von Solarzellen (1) mit entsprechenden elektrischen Anschlüssen (2), gemäß einem oder mehreren der Ansprüche 4 bis 6;
- einen Roboterarm, der mit einem Ende versehen ist, das einen Gehäuseflansch für den Kupplungsflansch (201) aufweist;
- eine computergestützte und programmierbare Datenverarbeitungseinheit, die in der Lage ist, die Bewegung des Roboterarms und/oder des Stellantriebs (10) zum Greifen und Schweißen zu steuern;
wobei die Datenverarbeitungseinheit in der Lage ist, die Steuereinheit der Schnittstellenvorrichtung (200) zum Betätigen der Schweißvorrichtung (130) der Vorrichtung (100) zum Greifen und Schweißen zu steuern.

## Revendications

1. Dispositif (100) de préhension et de soudage de cellules solaires (1) avec un connecteur électrique correspondant (2) pour la construction d'une chaîne de cellules solaires, comprenant:
- des moyens d'aspiration (110) aptes à maintenir pendant l'utilisation la cellule solaire (1) ou le connecteur électrique (2) et définissant une zone de préhension de ladite cellule solaire (1) ou dudit connecteur électrique (2);
- des moyens de soudage (130) dudit connecteur électrique (2) à ladite cellule solaire (1) et définissant une zone de soudage dudit connecteur électrique (2), aptes à chauffer pendant l'utilisation ladite zone de soudage pour faire fondre ledit connecteur électrique (2);
et étant **caractérisé en ce que**:
lesdits moyens d'aspiration (110) sont mobiles par rapport auxdits moyens de soudage (130) entre une position de préhension (GP), dans lequel lesdits moyens d'aspiration (110) retiennent ladite cellule solaire (1) ou ledit connecteur électrique (2) espacé de ladite soudure zone, et une position de soudage (WP), dans laquelle lesdits moyens d'aspiration (110) retiennent ledit connecteur électrique (2) au niveau de ladite zone de soudage en contact avec lesdits moyens de soudage (130) pendant la fusion de la couche de soudage dudit connecteur électrique (2), et
dans lequel lesdits moyens d'aspiration (110) et lesdits moyens de soudage (130) sont alignés le long d'un axe d'alignement parallèle à ladite zone de préhension et à ladite zone de soudage dans ladite position de soudage (WP);
dans lequel lesdits moyens d'aspiration (110) sont constitués de deux conduits d'aspiration (112) alignés le long dudit axe d'alignement,
dans lequel ledit dispositif (100) de préhension et de soudage comprend des moyens élastiques connectés fonctionnellement auxdits conduits d'aspiration (112) pour déplacer lesdits conduits d'aspiration (112) entre ladite position de préhension (GP) et ladite position de soudage (WP), et
vice versa,
dans lequel lesdits moyens élastiques sont précontraints pour maintenir lesdits conduits d'aspiration (112) dans ladite position de préhension (GP) et permettre auxdits conduits d'aspiration (112) d'être agencés dans ladite position de soudage (WP) lorsque lesdits conduits d'aspiration (112) sont soumis faire pression sur un support,
dans lequel lesdits moyens de soudage (130) comprennent une pointe de soudage qui définit ladite zone de soudage,
dans lequel lesdits conduits d'aspiration (112) et ladite pointe de soudage sont alignés le long dudit axe d'alignement dans ladite position de soudage (WP), et
dans lequel ladite pointe de soudage est disposée côté à côte avec lesdits conduits d'aspiration (112).

2. Dispositif (100) de préhension et de soudage selon la revendication 1, comprenant un châssis support (150) et des moyens de positionnement desdits moyens d'aspiration (110) et desdits moyens de soudage (130) audit châssis support (150), dans lequel lesdits moyens de positionnement sont aptes à permettre le mouvement relatif desdits moyens d'aspiration (110) et desdits moyens de soudage (130) par rapport audit cadre de support (150) pour modifier le positionnement de ladite zone de préhension par rapport à ladite zone de soudage dans ladite prise (GP).

3. Dispositif (100) de préhension et de soudage selon la revendication 2, dans lequel lesdits moyens de positionnement comprennent une première équerre de support (150'), apte à relier fonctionnellement lesdits moyens d'aspiration (110) audit cadre de support (150), et un une seconde console de support (150 "), capable de relier fonctionnellement lesdits moyens de soudage (130) audit châssis de support (150),
dans lequel lesdits moyens d'aspiration (110) et lesdits moyens de soudage (130) sont capables de se déplacer, respectivement vers ledit premier support de support (150') et ledit second support de support (150"), le long d'une direction perpendiculaire audit axe d'alignement.

4. Tête d'actionnement (10) pour un bras robotique pour saisir et souder des cellules solaires avec des connecteurs électriques correspondants pour la construction d'une chaîne de cellules solaires, comprenant:
- un dispositif (100) de préhension et de soudage de cellules solaires (1) avec des connecteurs électriques correspondants (2) pour la réalisation d'une chaîne de cellules solaires, selon une ou plusieurs revendications de 1 à 3;
- - un dispositif d'interface (200) pourvu d'une bride d'accouplement (201) pour ledit bras robotique et apte à relier fonctionnellement ledit dispositif (100) pour saisir et souder ledit bras robotique;
dans lequel ledit dispositif (100) de préhension et de soudage comprend au moins une première broche d'interface mécanique (151),
dans lequel ledit dispositif d'interface (200) comprend au moins un premier connecteur d'interface mécanique (251) capable de s'accoupler avec ladite première broche d'interface mécanique (151),
dans lequel ladite première broche d'interface mécanique (151) et ledit premier connecteur d'interface mécanique (251) ont respectivement une ouverture traversante (153, 253) qui définit, lorsqu'ils sont couplés, un premier conduit d'air pour alimenter lesdits moyens d'aspiration (110).

5. Tête d'actionnement (10) de préhension et de soudage selon la revendication 4, dans laquelle ledit dispositif d'interface (200) comprend des moyens d'alimentation en air comprimé (220) et au moins un dispositif Venturi, fonctionnellement connectés auxdits moyens d'alimentation en air comprimé (220). et auxdits moyens d'aspiration (110), pour obtenir une force d'aspiration sur lesdits moyens d'aspiration (110) par l'alimentation en air comprimé dans le dispositif Venturi.

6. Tête d'actionnement (10) de préhension et de soudage selon la revendication 4 ou 5, dans laquelle ledit dispositif (100) de préhension et de soudage comprend une première broche d'interface mécanique (151) et une deuxième broche d'interface mécanique (152),
dans lequel ledit dispositif d'interface (200) comprend un premier connecteur d'interface mécanique (251) et un second connecteur d'interface mécanique (252),
dans lequel ledit premier connecteur d'interface mécanique (251) et / ou ledit deuxième connecteur d'interface mécanique (252) peuvent être actionnés entre une position de fonctionnement, dans lequel ledit premier connecteur d'interface mécanique (251) et / ou ledit deuxième connecteur d'interface mécanique (252) sont respectivement couplés à ladite première broche d'interface mécanique (151) et / ou à ladite deuxième broche d'interface mécanique (152), et une position de repos, dans laquelle ledit premier connecteur d'interface mécanique (251) et / ou ledit deuxième connecteur d'interface mécanique (252) sont respectivement découplés à partir de ladite première broche d'interface mécanique (151) et / ou de ladite seconde broche d'interface mécanique (152),
dans lequel ledit dispositif d'interface (200) comprend un moteur électrique connecté fonctionnellement audit premier connecteur d'interface mécanique (251) et / ou audit second connecteur d'interface mécanique (252) pour modifier la distance mutuelle entre ledit premier connecteur (251) et ladite seconde interface mécanique connecteur (252).

7. Un robot pour saisir et souder des cellules solaires avec des connecteurs électriques correspondants pour la réalisation d'une chaîne de cellules solaires en accord, comprenant:
- une tête d'actionnement (10) pour saisir et souder des cellules solaires (1) avec des connecteurs électriques respectifs (2), selon une ou plusieurs revendications de 4 à 6;
- un bras robotisé pourvu d'une extrémité comprenant une bride de boîtier pour ladite bride d'accouplement (201);
- une unité informatique et programmable de traitement de données apte à contrôler le mouvement dudit bras robotique et / ou de ladite tête d'actionnement (10) pour la préhension et le soudage;
dans lequel ladite unité de traitement de données est capable de commander ladite unité de commande dudit dispositif d'interface (200) pour actionner lesdits moyens de soudage (130) dudit dispositif (100) pour la préhension et le soudage.
